# EUROPÄISCHE PATENTANMELDUNG

(11) **EP 2 289 658 A1**
(43) Veröffentlichungstag der Anmeldung: **02.03.2011**
(21) Anmeldenummer: 09169030.5
(22) Anmeldetag: 31.08.2009
(51) Int. Cl.: B23K 1/00, B23K 1/06, H01L 31/05

(54) **Verfahren und Vorrichtung zum Verlöten von Verbindungsleitern mit einer Solarzelle**

(71) Anmelder: MTA Automation AG, 3238 Gals (CH)
(72) Erfinder: Knuchel, Claude-Alain, 2603 Péry (CH); Stornaiuolo, Emilio, 3280 Murten (CH)
(74) Vertreter: AMMANN PATENTANWÄLTE AG BERN

(57) **Zusammenfassung**

Bei einem Verfahren und einer Vorrichtung zum Verlöten von Verbindungsleitern (8, 9, 35-38) mit den Anschlusskontakten (11, 12) einer Solarzelle (7, 43, 44) soll ein Produktivitätsgewinn bzw. eine Qualitätsverbesserung ermöglicht werden und insbesondere ein direktes Verlöten der Verbindungsleiter an die Solarzelle mittels Ultraschall ermöglicht werden.

Bei dem Verfahren wird vorgeschlagen, dass vor dem Aufschmelzen des Lots (15, 17) auf die Anschlusskontakte (11, 12) die Solarzelle (7, 43, 44) und die Verbindungsleiter (8, 9, 35-38) aufeinanderliegend auf einer Ebene (3, 51) positioniert werden, dass die Stapelanordnung (19) homogen erhitzt wird und dass mindestens ein Aktivierungsglied (4, 52-56, 70) von oben an die Stapelanordnung herangeführt wird, durch welches Ultraschallschwingungen auf die Stapelanordnung (19) übertragen werden und dadurch zusätzliche Energie zum flussmittelfreien Verlöten zugeführt wird.

Die Vorrichtung weist hierzu eine Heizebene (3, 51) auf, sowie mindestens ein Aktivierungsglied (4, 52-56, 70), das oberhalb der Heizebene (3, 51) angeordnet ist und von oben an die Stapelanordnung (19) heranführbar ist, wobei das Aktivierungsglied (4, 52-56, 70) zur Übertragung von Ultraschallschwingungen auf die Stapelanordnung (19) ausgebildet ist.

## Beschreibung

Die Erfindung betrifft ein Verfahren zum Verlöten von Verbindungsleitern mit den Anschlusskontakten einer Solarzelle nach dem Oberbegriff von Patentanspruch 1. Weiterhin bezieht sich die Erfindung auf eine gattungsgemässe Vorrichtung nach dem Oberbegriff von Patentanspruch 10 sowie auf eine Solarzellenkette, die durch ein solches Verfahren und/oder mit einer solchen Vorrichtung herstellbar ist.

Photovoltaik-Anlagen zur Umwandlung von Sonnenenergie in elektrische Energie bestehen aus mehreren Solarzellen, die zur Erbringung der geforderten Leistung in grösseren Moduleinheiten zu Ketten miteinander verschaltet sind. Zur Herstellung einer solchen Solarzellenkette müssen Verbindungsleiter an die Anschlusskontakte der Solarzellen angebracht werden, was oftmals durch Löten, insbesondere Weichlöten, bewerkstelligt wird.

Ein derartiges Lötverfahren ist aus der DE 36 12 269 A1 bekannt, wobei zum Erwärmen der Solarzellen auf eine Löttemperatur von 190-240 °C eine Halogenlampe verwendet wird, deren wesentliche Strahlungsintensität in dem Wellenlängenbereich mit der grössten spektralen Empfindlichkeit der Solarzellen angesiedelt ist. Dadurch ist eine Erwärmung der Solarzellen von Umgebungstemperatur in den Bereich der geforderten Löttemperatur innerhalb ca. 2 Sekunden ermöglicht. Zur Durchführung dieses Verfahrens werden eine oder mehrere Solarzellen in eine Bestrahlungskammer eingesetzt und auf die unterseitigen bzw. oberseitigen Anschlusskontakte die jeweiligen Verbindungsleiter aufgelegt.

Das Einsetzen der jeweiligen Solarzellen in die Strahlungskammer ist notwendig, um einerseits die benötigte hohe Strahlungsleistung von ca. 1250 W zur Verfügung zu stellen und um andererseits den Aussenraum hermetisch von der Strahlungswirkung abzuschirmen. Dieser Vorgang bringt jedoch einen Zeitverlust mit sich und stellt einen Hemmfaktor für die Effizienz dieses Verfahrens dar, insbesondere im Rahmen einer industriellen Massenproduktion. Ebenso nachteilig ist der hohe Temperaturunterschied, der während des Lötens überwunden werden muss und ein genaues Einstellen einer optimalen Löttemperatur nur schwer möglich macht, so dass mit Qualitätseinbussen des Lötergebnisses zu rechnen ist. Ferner wird zur Durchführung des Lötens ein Flussmittel benötigt, dessen Vermeidung sowohl zur Verbesserung des Lötergebnisses als auch aus verfahrensökonomischen Gründen wünschenswert wäre.

Die WO 2008/014900 A1 beschreibt ein Verfahren zum Anlöten eines Verbindungsleiters an eine Solarzelle, wobei das Lot mittels Ultraschall auf die Solarzelle aufgebracht wird und anschliessend der Verbindungsleiter aufgelegt und unter Zuführung thermischer Energie durch das Lot mit der Solarzelle verbunden wird. Dadurch wird die Verwendung eines Flussmittels vermieden.

Auch bei diesem dreistufigen Lötprozess wäre eine Effizienzverbesserung wünschenswert, da dem Positionieren der Verbindungsleiter auf den Anschlusskontakten und dem eigentlichen Lötvorgang die zeitaufwändige Vorbehandlung des Lots durch eine über die Anschlusskontakte bewegte Ultraschall-Sonotrode vorgeschaltet ist. Ein direktes Anlöten eines Verbindungsleiters an die Solarzelle mittels Ultraschall wird jedoch vermieden, da bei dem vorgeschlagenen Verfahren durch die Einwirkung von Ultraschallschwingungen eine Beschädigung der Solarzelle zu befürchten ist. Bei diesem Verfahren ist insbesondere ein simultanes Anlöten mehrerer Verbindungsleiter sehr aufwändig, da die Sonotrode vor dem Löten sukzessive über sämtliche Anschlusskontakte geführt werden muss. Ein simultanes Anlöten auf verschiedenen Solarzellenseiten erfordert zusätzlich einen Seitenwechsel der Ultraschalleinwirkung bzw. ein Umdrehen der Solarzelle.

Eine Aufgabe der vorliegenden Erfindung besteht daher darin, ein Verfahren und eine Vorrichtung der eingangs genannten Art anzugeben, die im Vergleich zu einem herkömmlichen Lötverfahren einen Produktivitätsgewinn und/oder eine Qualitätsverbesserung ermöglichen und/oder ein Verfahren und eine Vorrichtung bereitzustellen, die zum direkten Verlöten des Verbindungsleiters an eine Solarzelle mittels Ultraschall ausgebildet ist, ohne eine Beschädigung der Solarzelle in Kauf nehmen zu müssen.

Diese Aufgabe wird durch das Verfahren gemäss Patentanspruch 1 und durch die Vorrichtung gemäss Patentanspruch 10 gelöst.

Die weiteren Patentansprüche geben bevorzugte Ausführungsformen dieses Verfahrens und dieser Vorrichtung an.

Bei dem erfindungsgemässen Verfahren wird also vorgeschlagen, dass vor dem Aufschmelzen des Lots auf die Anschlusskontakte die Solarzelle und die Verbindungsleiter in einer Stapelanordnung aufeinanderliegend auf einer Ebene positioniert werden, so dass mindestens ein Verbindungsleiter oberhalb und/oder mindestens ein Verbindungsleiter unterhalb einer Solarzelle angeordnet ist. Die Positionierung auf einer Ebene hat einerseits den Vorteil, dass zum Verlöten der Stapelanordnung ein darüberliegender Freiraum zur Anordnung einer geeigneten Löteinrichtung geschaffen ist, für welche ein einfaches Heran- und Wegführen an die Oberseite der Stapelanordnung ermöglicht ist. Andererseits eröffnet dies den Vorteil eines einfachen An- und Abtransports von zu verlötenden Solarzellen in horizontaler Richtung, beispielsweise durch eine vor bzw. hinter der Ebene liegende Förder- oder Transfereinrichtung, wodurch insbesondere die Fertigung einer im Prinzip beliebig langen Solarzellenkette im Rahmen eines kontinuierlichen Verarbeitungsprozesses gewährleistet ist. Der einfache An- und Abtransport kann wiederum zur Beschleunigung des Herstellungsverfahrens einer solchen Solarzellenkette nutzbar gemacht werden, indem eine nachfolgend zu verlötende Solarzelle bereits in der Förder- oder Transfereinrichtung auf den Lötvorgang vorbereitet wird. Beispielsweise kann während des Verlötens einer Solarzelle mit den Verbindungsleitern auf der Ebene ein aufeinanderliegendes Positionieren von einer nachfolgend zu verlötenden Solarzelle und mindestens einem Verbindungsleiter bereits auf der Förder- oder Transfereinrichtung durchgeführt werden.

Ein weiterer Grundgedanke der Erfindung besteht darin, dass die Stapelanordnung homogen erhitzt wird und dass mindestens ein Aktivierungsglied von oben an die Stapelanordnung herangeführt wird, durch welches an einem statischen Ort Ultraschallschwingungen auf die jeweilige Stapelanordnung übertragen werden und derart zusätzliche Energie zum flussmittelfreien Verlöten zugeführt wird. Die Anordnung eines solchen Aktivierungsglieds an einem bezüglich der Lötstelle externen Einwirkungsbereich auf der Oberseite der Stapelanordnung ist erfindungsgemäss dadurch möglich, dass während des Verfahrens, vorzugsweise vor der Durchführung des eigentlichen Lötvorgangs, zusätzlich ein homogenes Aufheizen der Stapelanordnung durchgeführt wird. Die Erfindung beruht also auf der Erkenntnis, dass eine externe Einwirkung von Ultraschall zumindest in dreierlei Hinsicht vorteilhaft für die Verlötung der Stapelanordnung genutzt werden kann, welche durch homogenes Aufheizen auf den Lötvorgang vorbereitet wurde:

Zum einen wird durch die Ultraschallvibrationen ein Auflösen der auf einem Lot vorhandenen Oxidschicht herbeigeführt, wodurch die zusätzliche Anwendung eines Flussmittels zur Durchführung des Lötvorgangs vermieden werden kann. Erfindungsgemäss ist es dabei aufgrund der homogenen Vorheizung ausreichend, dass das Aktivierungsglied zur Ultraschallerzeugung auf einen äusseren Bereich der Stapelanordnung einwirkt und nicht direkt mit dem Lot bzw. der Lötstelle kontaktiert werden muss, was ein oberes Heranführen des Aktivierungsglieds an einen externen auf der Aussenfläche der Stapelanordnung angeordneten Arbeitspunkt erlaubt und somit eine erhebliche Vereinfachung bei der Durchführung des Verfahrens mit sich bringt. Beispielsweise kann das Aktivierungsglied direkt mit einem Bereich der Solarzellenoberfläche kontaktiert werden, der zwischen zwei Verbindungsleitern angeordnet ist, um ein simultanes Verlöten der beiden Verbindungsleiter durchzuführen. Alternativ kann das Aktivierungsglied auch von oben auf einem Verbindungsleiter plaziert werden. Dabei ist durch die Einwirkung des oberseitig angeordneten Aktivierungsglieds auch ein flussmittelfreies Verlöten eines unterseitigen Verbindungsleiters mit der Solarzelle ermöglicht.

Der zweite vorteilhafte Synergieeffekt zwischen dem homogenen Aufheizen und dem von oben einwirkenden Aktivierungsglied besteht darin, dass durch eine derartige Anordnung die in die Stapelanordnung eingebrachten Ultraschallvibrationen einen Beitrag zu der für den Lötvorgang benötigten Lötenergie liefern können. Bei einem Verlöten mit einer vollständigen Aufheizung ausgehend von der Umgebungstemperatur liefert dieser Vibrationseffekt nur einen geringen energetischen Beitrag bezüglich des dabei zu überwindenden Temperaturunterschieds ausgehend von der Umgebungstemperatur. Durch eine erfindungsgemässe homogene Vorheizung vor der Durchführung des eigentlichen Lötvorgangs kann die Energiezufuhr durch die eingeleiteten Ultraschallvibrationen zumindest teilweise für die Einstellung einer gewünschten Löttemperatur nutzbar gemacht werden.

Drittens wird durch das erfindungsgemässe homogene Aufheizen ermöglicht, dass eine im Wesentlichen lokalisierte Anwendungsposition des Aktivierungsglied an dem statischen externen Arbeitspunkt zum Erreichen des gewünschten Lötergebnisses ausreichend ist und somit ein zeitaufwändiges Deplazieren des Aktivierungsglieds über die Solarzellenoberfläche hinweg entlang der herzustellenden Verlötung vermieden werden kann.

Bevorzugt wird durch das homogene Erhitzen ein Aufheizen der Stapelanordnung auf eine Temperatur unterhalb der Löttemperatur durchgeführt und durch das Aktivierungsglied zusätzliche Energie zum Erreichen der Löttemperatur auf die Stapelanordnung übertragen. Beispielsweise kann die Löttemperatur im Wesentlichen der Schmelztemperatur des Lots entsprechen. Prinzipiell ist dabei denkbar, wenn das Lot durch die Einwirkung der homogenen Vorheizung nahe genug an den Schmelzpunkt herangeführt wird, dass zur Durchführung des Lötvergangs im Wesentlichen nur Ultraschallschwingungen durch das Aktivierungsglied erzeugt und an die Stapelanordnung weitergeleitet werden, um dabei die thermische Energie der Ultraschallvibrationen auszunutzen.

Eine besonders effiziente Durchführung des Verfahrens kann dadurch erreicht werden, dass die Ebene eine Heizebene ist, in der Wärme erzeugt wird und an die Stapelanordnung weitergeleitet wird, wodurch das homogene Erhitzen der Stapelanordnung erzielt wird. Denn durch die flächige Einwirkung der unteren Heizebene kann einerseits ein homogenes Aufheizen und andererseits ein unbehindertes Heranführen des oberen Aktivierungsglieds durchgeführt werden. Durch eine derartige Heizebene kann insbesondere erreicht werden, dass die Stapelanordnung vor der eigentlichen Verlötung der Verbindungsleiter an die herzustellenden Prozessbedingungen, insbesondere an die zu erreichende Löttemperatur, angeglichen wird und der anschliessende Lötvorgang beschleunigt und präziser durchführbar ist. Durch die ebene Form des Heizelements ist dabei ein gleichverteiltes Erhitzen der Stapelanordnung gewährleistet. Derart kann beispielsweise bereits während des Lötens einer vorhergehend zu bearbeitenden Stapelanordnung die nachfolgend zu lötende Stapelanordnung auf den Lötvorgang vorbereitet werden.

Zum Erreichen einer besseren Reproduzierbarkeit des Lötvorgangs wird vorgeschlagen, dass durch mindestens ein Aktivierungsglied sowohl in diesem erzeugte Wärme als auch durch dieses erzeugte Ultraschallschwingungen in die Stapelanordnung eingeleitet werden. Erfindungsgemäss wird dabei neben den Ultraschallschwingungen zusätzliche Wärmenergie von oben der Stapelanordnung zugeführt, wobei durch das homogene Aufheizen, vorzugsweise durch die untere Heizebene, eine punktuelle zusätzliche Wärmezufuhr des Aktivierungsglieds von dem oberen statischen Einwirkungsort ausreichend ist. Dies ermöglicht eine einfachere Kontrolle des Lötvorgangs bei gleichbleibend hoher Effizienz im Rahmen einer Massenproduktion. Vorzugsweise ist hierzu die Heiztemperatur der Heizebene unterhalb der gewünschten Löttemperatur gewählt, beispielsweise in einem Bereich zwischen 10 K und 30 K unterhalb der Schmelztemperatur des Lots. Erfindungsgemäss sind dabei auch Temperaturbereiche erfasst, in denen die thermische Wirkung der übertragenen Ultraschallvibrationen gering ist gegenüber der zusätzlichen Heizwirkung des Aktivierungsglieds.

Um eine möglichst rasche Verfestigung des Lots nach dessen Erhitzen zu erzielen, wird vorgeschlagen, dass nach dem Erreichen der Löttemperatur das Aktivierungsglied von der Stapelanordnung weggeführt wird, wobei mindestens ein Wärmeabführglied mit der Stapelanordnung in Kontakt steht. Ein derartiges Wärmeabführglied kann beispielsweise von oben an die zu verlötenden Verbindungsleiter herangeführt werden. Zusätzlich kann ein solches Wärmeabführglied zur Kraftbeaufschlagung der Stapelanordnung während des Lötvorgangs dienen.

Eine bessere Reproduzierbarkeit des Lötergebnisses kann auch dadurch erreicht werden, dass neben dem Aktivierungsglied zum Einleiten der Ultraschallschwingungen mindestens ein weiteres Aktivierungsglied verwendet wird, in welchem im Wesentlichen nur Wärme erzeugt wird, die in die Stapelanordnung einleitbar ist. Gemäss einer besonders vorteilhaften Ausgestaltung ist jeweils ein Aktivierungsglied zur Ultraschallerzeugung zwischen zwei Aktivierungsgliedern zur Erzeugung von Wärme angeordnet.

Gemäss einer bevorzugten Weiterbildung des erfindungsgemässen Verfahrens wird zunächst nur in einem Aktivierungsglied erzeugte Wärme in die Stapelanordnung eingeleitet und anschliessend werden zusätzlich Ultraschallschwingungen eingeleitet. Dies hat den Vorteil, dass eine homogene Verflüssigung des Lots und somit eine homogene Ausbreitung der Ultraschallvibrationen sichergestellt ist. Beispielsweise kann eine solche Vorheizwirkung des Aktivierungsglieds innerhalb eines Zeitraums von weniger als fünf Sekunden vorgesehen sein.

Vorzugsweise werden bei dem erfindungsgemässen Verfahren Verbindungsleiter verwendet, die auf der zur Solarzelle zugewandten Seite jeweils eine Beschichtung aufweisen, durch die ein Lot gebildet ist. Beispielsweise kann es sich um vorverzinnte Verbindungsleiter handeln. Dadurch gestaltet sich das Aufbringen des Lots in der Stapelanordnung besonders einfach. Alternativ kann auch ein separates Auftragen des Lots zwischen den Verbindungsleitern und den Anschlusskontakten durchgeführt werden.

Eine erfindungsgemässe Vorrichtung zur Durchführung des Verfahrens umfasst einerseits eine Heizebene zum Positionieren der Solarzellen und der Verbindungsleiter in einer Stapelanordnung und zur Erzeugung und Weiterleitung von Wärmeenergie an die Stapelanordnung und andererseits mindestens ein Aktivierungsglied, das oberhalb der Heizebene angeordnet ist und von oben an die Stapelanordnung heranführbar ist, wobei das Aktivierungsglied zur Übertragung von Ultraschallschwingungen auf die Stapelanordnung ausgebildet ist.

Vorzugsweise sind dabei mehrere Aktivierungsglieder und/oder Wärmeabführglieder in einer Horizontalreihe parallel zur Heizebene angeordnet, um eine optimale Energieeinleitung in die Stapelanordnung sicherzustellen. Dies kann insbesondere dadurch erreicht werden, dass mindestens ein Aktivierungsglied zur Erzeugung von Ultraschallschwingungen zwischen zwei beheizbaren Aktivierungsgliedern oder zwischen zwei Wärmeabführgliedern angeordnet ist. Beispielsweise kann dabei eine relative Beabstandung zwischen 10 mm und 50 mm vorgesehen sein.

Bevorzugt sind die Aktivierungsglieder und/oder die Wärmeabführglieder im Wesentlichen zylinderförmig ausgebildet. Beispielsweise ist ein Zylinderdurchmesser von ca. 3 mm bis 5 mm denkbar.

Zum Einleiten der Ultraschallschwingungen und/oder der zusätzlichen Heizenergie ist erfindungsgemäss eine im Wesentlichen punktförmige oder kreisförmige oder gleichseitige Kontaktfläche des Aktivierungselements mit der Stapelanordnung denkbar. Um eine besonders effektive Einleitung der Ultraschallschwingungen zu erzielen, kann weiterhin vorgesehen sein, dass das Aktivierungsglied an seinem freien Ende eine mehrfortsätzige Oberflächenstruktur aufweist. Beispielsweise kann es sich dabei um ein kammförmiges Element handeln, das mehrere Einzelfortsätze in einer Längsreihe aufweist und das auf ein Aktivierungsglied zur Ultraschallerzeugung aufgesetzt ist. Ebenfalls ist eine flächige Anordnung von Einzelfortsätzen denkbar.

Nachfolgend ist die Erfindung anhand bevorzugter Ausführungsformen unter Bezugnahme auf die Zeichnungen näher erläutert, anhand welchen sich weitere Eigenschaften und Vorteile der Erfindung ergeben. Dabei zeigen:
- Fig. 1:: eine schematische Darstellung einer Vorrichtung zum Verlöten von Verbindungsleitern mit dem Anschlusskontakt einer Solarzelle;
- Fig. 2:: die in Fig. 1 gezeigte Vorrichtung, wobei eine Solarzelle und Verbindungsleiter in einer Stapelanordnung darauf positioniert sind;
- Fig. 3:: die in Fig. 2 gezeigte Vorrichtung und Stapelanordnung während des Verlötens der Verbindungsleiter;
- Fig. 4:: die in Fig. 2 und Fig. 3 gezeigte Vorrichtung und Stapelanordnung im Anschluss an den Lötprozess;
- Fig. 5:: eine perspektivische Darstellung einer Vorrichtung zum automatisierten Herstellen einer Solarzellenkette mittels einer Ultraschalllöteinheit;
- Fig. 6:: eine Detailansicht der Ultraschalllöteinheit in der in Fig. 5 gezeigten Vorrichtung;
- Fig. 7-9:: die in Fig. 5 gezeigte Vorrichtung bei der Durchführung aufeinanderfolgender Verfahrensschritte zur Herstellung einer Solarzellenkette; und
- Fig. 10:: eine Detailansicht eines Aktivierungsglieds zur Verwendung in einer Vorrichtung zum Verlöten von Verbindungsleitern mit dem Anschlusskontakt einer Solarzelle.

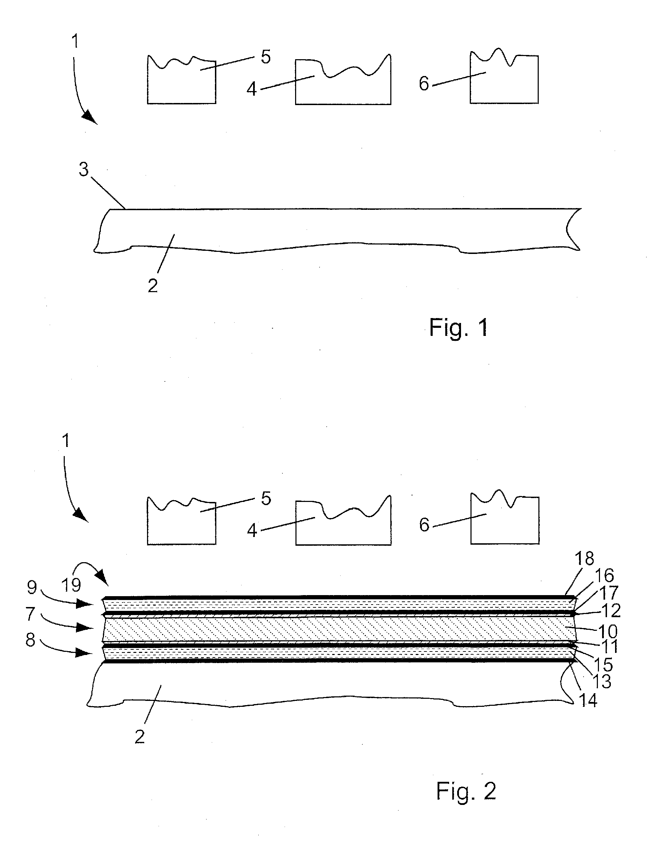

Die in Fig. 1 schematisch gezeigte Lötvorrichtung 1 umfasst eine Heizeinrichtung 2 mit einer ebenen Heizfläche 3. Oberhalb der Heizebene 3 ist ein Aktivierungsglied 4 angeordnet, dass ebenfalls beheizbar ist und weiterhin zur Erzeugung von Ultraschallschwingungen ausgebildet ist. Das Aktivierungsglied 4 ist im Wesentlichen kreiszylinderförmig ausgebildet und weist eine ebene Unterseite auf, über welche die Heizenergie und die Ultraschallschwingungen nach unten weiterleitbar sind. Beidseitig ist in jeweils gleicher Beabstandung von dem Aktivierungsglied 4 ein zylinderförmiges Wärmeabführglied 5, 6 angeordnet. Der Abstand zwischen dem Aktivierungsglied und den Wärmeabführgliedern beträgt ca. 10 bis 50 mm. Der radiale Durchmesser des Aktivierungsglieds 4 und der Wärmeabführglieder 5, 6 beträgt ca. 3 bis 6 mm. Die Wärmeabführglieder 5, 6 und das Aktivierungsglied 4 sind also entlang einer Querreihe angeordnet, die über die Heizebene 3 hinweg durch eine analoge Anordnung von weiteren Aktivierungsgliedern 4 und Wärmeabführgliedern 5, 6 fortgesetzt wird.

Die Fig. 2 zeigt die Lötvorrichtung 1, wobei zwei Verbindungsleiter 8, 9 und eine dazwischenliegende Solarzelle 7 auf der Heizebene 3 positioniert ist. Die Solarzelle 7 umfasst ein mono-kristallines oder multikristallines Siliziummaterial 10 an welches auf der Oberseite und auf der Unterseite jeweils streifenförmige Anschlusskontakte 11, 12 angebracht sind. Die Solarzellenoberfläche ist im Wesentlichen quadratisch ausgebildet mit einer Seitenlänge von ca. 90-160 mm und einer Dicke von ca. 170-230 µm. Entlang des unterseitigen Kontaktstreifens 11 ist die Solarzelle 7 auf den unteren Verbindungsleiter 8 aufgelegt, während der obere Verbindungsleiter 9 auf dem oberen Kontaktstreifen 12 aufliegt. Derart ist eine Stapelanordnung 19 von Solarzelle 7 und Verbindungsleitern 8, 9 gebildet. Die Verbindungsleiter 8, 9 sind ebenfalls streifenförmig ausgebildet und jeweils auf ihrer Ober- und Unterseite mit einem Lot 14, 15, 17, 18 beschichtet. Zum kontinuierlichen An- und Abtransport von derartigen Stapelanordnungen 19 ist die Heizebene 3 mit einer Fördereinrichtung verbunden.

Nachfolgend ist anhand der Figg. 2 bis 4 ein Verfahren zum Verlöten der Verbindungsleiter 8, 9 mit den Anschlusskontakten 11, 12 der Solarzelle 7 beschrieben:

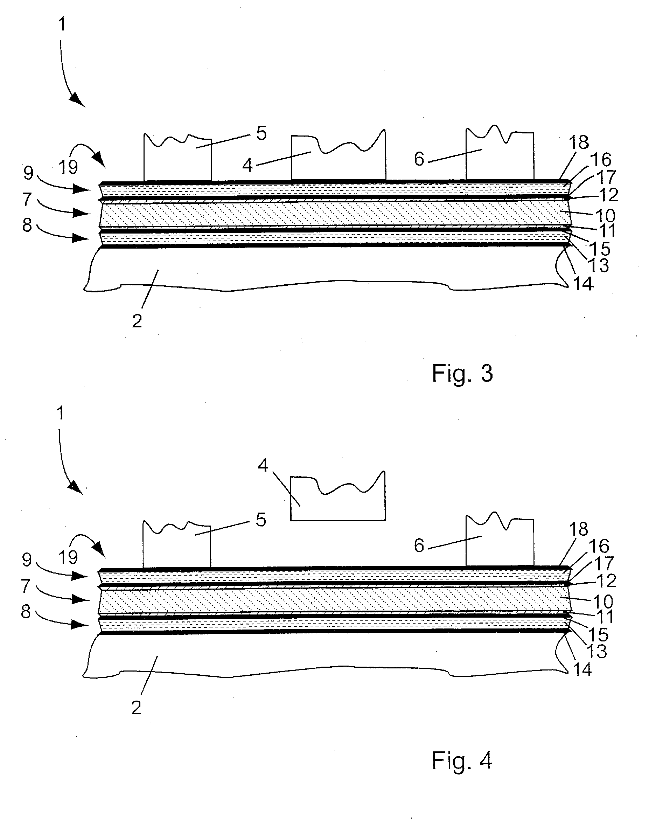

Durch das Antransportieren und Positionieren der Stapelanordnung 19 auf der Heizebene 3, wie dies in Fig. 2 gezeigt ist, erfolgt ein homogenes Erhitzen derselben auf ca. 20 K unterhalb der Löttemperatur. Im folgenden Schritt gemäss Fig. 3 werden das Aktivierungsglied 4 und die Wärmeabführglieder 5, 6 an die Oberseite des oberen Verbindungsleiters 9 herangeführt, wodurch eine Kraftbeaufschlagung der Stapelanordnung 19 in Richtung der Heizebene 3 stattfindet. Gleichzeitig wird durch das Aktivierungsglied 4 Wärme an die Stapelanordnung zugeführt, wodurch die Schmelztemperatur des Lots 14, 15, 17, 18 überschritten wird. Nach Verflüssigung des Lots 14, 15, 17, 18 werden durch das Aktivierungsglied 4 zusätzlich Ultraschallschwingungen in die Stapelanordnung eingeleitet, wodurch eine Oxidschicht of dem verflüssigten Lot 14, 15, 17, 18 entfernt wird. Im nächsten Schritt gemäss Fig. 4 wird das Aktivierungsglied 4 von der Stapelanordnung 19 weggeführt, so dass nur noch die Wärmeabführglieder mit der Stapeloberfläche in Berührung stehen und eine rasche Abkühlung des Lots bewirkt wird.

Gemäss einer zweiten Ausführungsform einer erfindungsgemässen Vorrichtung ist das Aktivierungsglied 4 nur zur Übertragung von Ultraschallschwingungen ausgebildet und anstelle der Wärmeabführglieder 5, 6 jeweils ein beheizbares Aktivierungsglied vorgesehen, durch welche die zusätzliche Wärmeenergie in die Stapelanordnung 19 einleitbar ist.

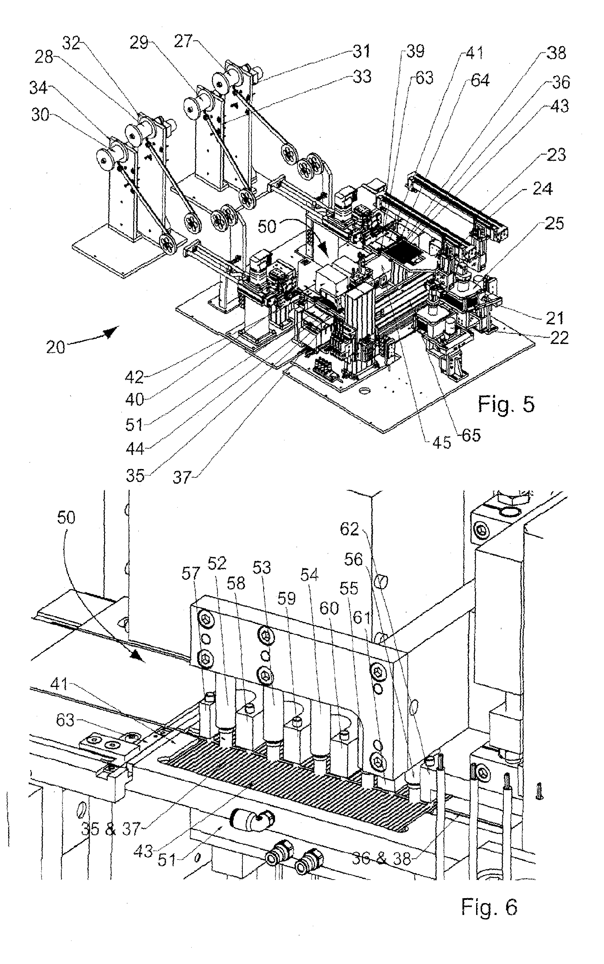

Fig. 5 zeigt eine Vorrichtung 20 zum automatisierten Herstellen einer Solarzellenkette mittels eines Ultraschalllötverfahrens. Die Vorrichtung 20 umfasst eine Beladungseinheit 21 zur Lagerung und Zuführung der zu verarbeitenden Solarzellen und eine Entladungseinheit 22 zur Abgabe der verarbeiteten und korrekt verlöteten Solarzellen. Die Zuführung und Abgabe der Solarzellen erfolgt mittels eines Beladungsarms 23 und eines Entladungsarms 24, die jeweils mit einem Greifer 25, 26 ausgestattet sind, der zur Aufnahme einer oberen Solarzelle von einem Solarzellenstapel geeignet ist.

Die mit den Solarzellen zu verlötenden Verbindungsleiter sind in Form von mit einem Lot beschichteten Kupferbändern auf vier Rollen 27, 28, 29, 30 aufgewickelt, die mit jeweils einem Abwickler 31, 32, 33, 34 wirkverbunden sind. Derart sind für jede Solarzelle als Verbindungsleiter jeweils zwei obere Bänder 35, 36 und zwei untere Bänder 37, 38 verfügbar, die durch jeweils eine obere und eine untere Vorschub- und Schneideeinrichtung 39, 40 zurechtgeschnitten und in eine Weiterverarbeitungsposition gebracht werden können.

Zur effizienten Durchführbarkeit des Lötverfahrens sind zwei Träger 41, 42 vorgesehen, durch welche in einen jeweiligen Verarbeitungszyklus zwei Solarzellen 43, 44 einbezogen werden können. Zur Fixierung der Solarzellen 43, 44 auf den Trägern 41, 42 sind auf jedem Träger 41, 42 zwei pneumatische Haltemittel 63, 64 vorhanden. Zur Umpositionierung der Träger 41, 42 zwischen einer Lade -bzw. Entladeposition, einer Zwischenposition und einer Lötposition ist jeweils eine motorisierte Transfereinrichtung 46, 47 vorgesehen. Das Verlöten der oberen Bänder 35, 36 und der unteren Bänder 37, 38 mit jeweils einer Solarzelle 43, 44 ist mittels der Ultraschalllöteinheit 50 durchführbar.

Fig. 6 zeigt die Ultraschalllöteinheit in einer Detailansicht. Zur Anordnung und Fixierung der Solarzellen 43, 44 und der oberen Bänder 35, 36 und unteren Bänder 37, 38 in einer Stapelanordnung, sowie zum homogenen Erhitzen derselben, ist eine Heizebene 51 vorgesehen. Oberhalb der Heizebene 51 sind in einer Querreihe und in gleicher Beabstandung fünf zylinderförmige Aktivierungsglieder 52-56 angeordnet. Derart ist ein Absenken der Aktivierungsglieder 52-56 auf ein oberes Band 35 der Stapelanordnung ermöglicht. Jedes der Aktivierungsglieder 52-56 ist zur Erzeugung und Übertragung sowohl von Ultraschall als auch von Heizenergie auf die Stapelanordnung ausgebildet. Neben den Aktivierungsgliedern 52-56 ist jeweils ein Niederhalter 57-62 angeordnet, der sowohl zur Fixierung des oberen Bands 35, 36 als auch zur Wärmeabfuhr nach Durchführung des Lötvorgangs ausgebildet ist.

In den Figg. 5-9 ist die Vorrichtung 20 zum automatisierten Herstellen einer Solarzellenkette in einer Folge von Verfahrensschritten eines Herstellungszyklus dargestellt, der nachfolgend anhand dieser Figuren detailliert beschrieben ist.

Während der in Fig. 5 gezeigten Position der Vorrichtung 20 werden im Wesentlichen drei Verfahrensschritte parallel zueinander durchgeführt:

Einerseits wird der Beladungsarm 23 über die Beladungseinheit 21 bewegt und eine Solarzelle 43 wird durch den Greifer 25 erfasst. Der Beladungsarm 23 bewegt sich über den Träger 41 und legt die Solarzelle 43 in einer Vertiefung des Trägers 41 ab. Die Solarzelle 43 wird durch Vakuum in ihrer Position auf dem Träger 41 gehalten.

Andererseits werden die zwei oberen Bänder 35, 36, die auf den Abwicklern 31, 32 jeweils zu einer Rolle 27, 28 aufgerollt sind, abgerollt und der Länge nach gestreckt gestreckt und durch die obere Vorschub- und Schneideeinrichtung 39 von der Rolle 27, 28 abgetrennt. Anschliessend werden die oberen Bänder 35, 36 auf die Oberseite der Solarzelle 43, die in der Vertiefung des Trägers 41 angeordnet ist, gelegt und durch die zwei pneumatischen Haltemittel 63, 64 in Position gehalten.

Weiterhin wird der Träger 42, auf dem die Solarzelle 44 angeordnet ist, in der Ultraschalllöteinheit 16 unterhalb der Aktivierungsglieder 52-56 positioniert. Die Heizebene 51 befindet sich zunächst in einer Position zur Auflage der unteren Bänder 37, 38 ausgebildet, die jeweils einem der Abwickler 33, 34 zu einer Rolle 29, 30 aufgerollt sind. Die zwei unteren Bänder 37, 38 werden nun abgerollt und der Länge nach gestreckt sowie durch die untere Vorschub- und Schneideeinrichtung 40 abgeschnitten. Anschliessend werden die geschnittenen unteren Bänder 37, 38 auf die Oberseite der Heizebene 51 gelegt und durch Vakuum in Position gehalten.

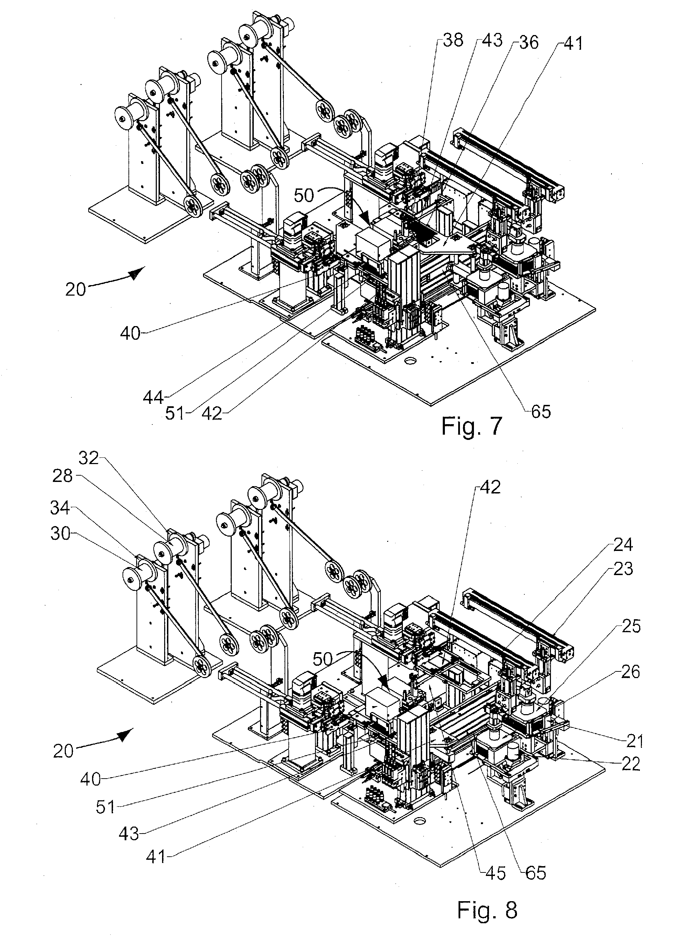

Während der in Fig. 7 gezeigten Position der Vorrichtung 20 werden folgende Verfahrensschritte durchgeführt:

Der Träger 41, auf dem die Solarzelle 43 und die zwei oberen Bänder 35, 36 auf der Oberseite der Solarzelle 43 angeordnet sind, wird durch die motorisierte Transfereinrichtung 65 in die Mittelposition gebracht. Durch eine Kamera wird die genaue Position der Solarzelle 43 gemessen, wodurch die durchzuführende Korrektur für den Lötvorgang ermittelt werden kann.

Die Heizebene 51 wird mittels einer pneumatischen Transfereinrichtung unter die Aktivierungsglieder 52-56 positioniert. Die untere Vorschub- und Schneideeinrichtung 40 fährt zurück in die Aufnahmeposition zur erneuten Bereitstellung der unteren Bänder 37, 38.

Der Träger 42 wird nach unten verfahren, so dass die Solarzelle 44 auf der Heizebene 51 angeordnet wird und derart die Stapelanordnung bestehend aus den unteren Bändern 37, 38, der Solarzelle 44 und den oberen Bändern 35, 36 gebildet ist, wobei die Solarzelle 44 mittels Vakuum auf der Heizebene 51 in Position gehalten wird. Der obere Teil der Ultraschalllöteinheit 50 wird vertikal mittels einer pneumatischen Transfereinrichtung verschoben, um derart die Aktivierungsglieder 52-56 und die Niederhalter 57-62 mit den oberen Bändern 35, 36 in Kontakt zu bringen und somit den Ultraschalllötvorgang zu starten. Am Ende des Lötvorgangs werden die Aktivierungsglieder 52-56 von der Oberfläche der Solarzelle 44 weggeführt, um ein beschleunigtes Abkühlen der Lötstellen in der Stapelanordnung herbeizuführen, welche sich jeweils zwischen den zwei unteren Bändern 37, 38 und der Unterseite der Solarzelle 44 und zwischen den zwei oberen Bändern 35, 36 und der Oberseite der Solarzelle 44 befinden. Durch die Niederhalter 57-62 wird einerseits eine Positionsfixierung der Stapelanordnung und andererseits ein beschleunigtes Abkühlen der Lötstellen erreicht. Nach dem Abkühlen werden die Niederhalter 57-62 und die Aktivierungsglieder 52-56 in ihre obere Freigabeposition zurückgeführt, so dass ein Loslösen des Trägers 42 von der Heizebene 51 möglich ist. Somit ist die mit den unteren Bändern 37, 38 und mit den oberen Bändern 35, 36 verlötete Solarzelle 44 bereit zur Entnahme.

Während der in Fig. 8 gezeigten Position der Vorrichtung 20 werden folgende Verfahrensschritte durchgeführt:

Der Träger 42 wird mittels der motorisierten Transfereinrichtung 45 in seine mittlere Position gebracht. Anschliessend wird die Qualität der mit den unteren Bändern 37, 38 und mit den oberen Bändern 35, 26 verlöteten Solarzelle 44 durch eine Kamera überprüft. Im Falle einer Gutheissung des Lötergebnisses wird die Solarzelle 44 durch den Entladungsarm 24 mit dem Greifer 26 aufgenommen und auf der Entladungseinheit 22 abgelegt. Andernfalls wird die Solarzelle 44 manuell oder automatisch ausgesondert.

Zwischenzeitlich wird der Träger 41 mittels der motorisierten Transfereinrichtung 65 unter die Aktivierungsglieder 52-56 der Ultraschalllöteinheit 50 positioniert und der voranstehend anhand von der Solarzelle 44 auf dem Träger 42 erläuterte Prozess wird nun mit der Solarzelle 43 auf dem Träger 41 wiederholt. Vorab wurden auf der Heizebene 51 erneut die unteren Bänder 37, 38 positioniert und mittels Vakuum in ihrer Position fixiert, um erneut zu einer Stapelanordnung bestehend aus der Solarzelle 43 und den oberen Bändern 35, 36 und den unteren Bändern 37, 38 zu gelangen.

Der leere Träger 42 wird durch die motorisierte Transfereinrichtung 45 in seine Ladeposition zurückgeführt und der voranstehend anhand von Träger 41 erläuterte Ladeprozess wird nun mit der folgenden zu verarbeitenden Solarzelle mit dem Träger 42 wiederholt.

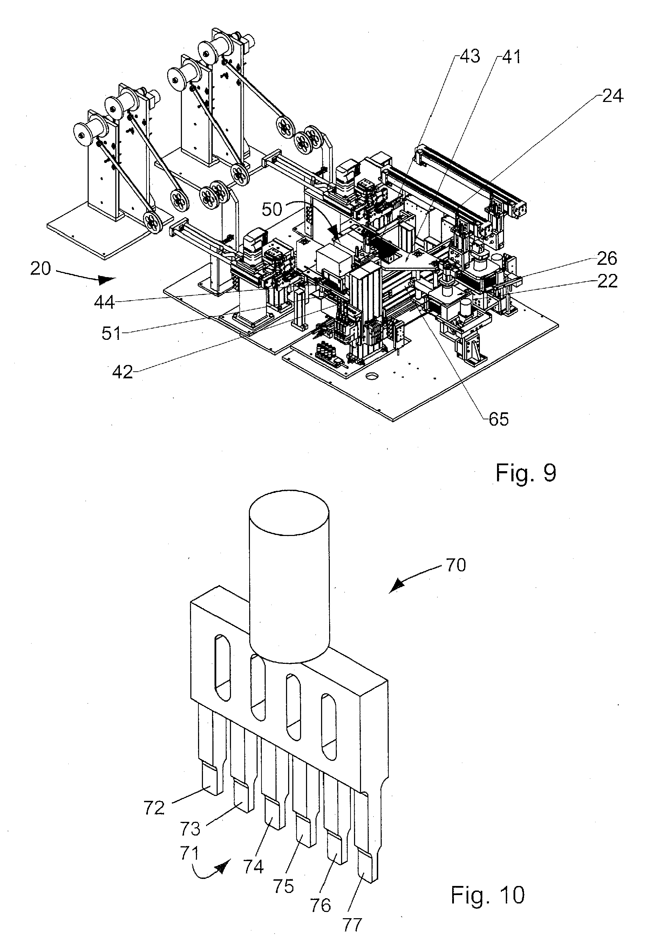

Während der in Fig. 9 gezeigten Position der Vorrichtung 20 werden folgende Verfahrensschritte durchgeführt:

Der Träger 41 wird wieder in seine Mittelposition geführt und die Qualität der mit den unteren Bändern 37, 38 und mit den oberen Bändern 35, 36 verlöteten Solarzelle 43 durch die Kamera überprüft und gemäss der voranstehenden Beschreibung entweder in der Entladungseinheit 22 abgelegt oder als Ausschuss aussortiert. Daraufhin wird der leere Träger 41 in seine Ladeposition zurückgeführt und der ausgehend von Fig. 5 beschriebene Prozess beginnt von Neuem.

Fig. 6 zeigt ein Aktivierungsglied 70 zur Verwendung in einer vorangehend beschriebenen Ultraschalllötvorrichtung 1, 50. An dem unteren freien Ende weist das Aktivierungsglied eine mehrzähnige Oberflächenstruktur 71 mit sechs Einzelfortsätzen 72-77 auf, die in einer Längsreihe angeordnet sind. Dadurch wird eine gleichmässige Einleitung von Ultraschallschwingungen in die Stapelanordnung über den von dem Aktivierungsglied 70 abgedeckten Oberflächenbereich der Stapelanordnung ermöglicht. Eine derartige Oberflächenstruktur 71 ist insbesondere beim Ultraschalllöten ohne Zuführung zusätzlicher Heizenergie durch das Aktivierungsglied 70 vorteilhaft, insbesondere bei alleiniger homogener Vorheizung beispielsweise durch eine Heizebene, um für eine über die Lötstelle gleichmässige Verteilung der durch den Ultraschall zusätzlich zugeführten Lötenergie zu sorgen.

Aus der vorangehenden Beschreibung sind dem Fachmann Abwandlungen des erfindungsgemässen Verfahrens und der Vorrichtung zugänglich, ohne den Schutzbereich der Erfindung zu verlassen, der allein durch die Patentansprüche definiert ist. Denkbar ist u.a.:
- Die Stapelanordnung 19 kann auch derart gewählt sein, dass sich die Verbindungsleiter 8, 9 nur über einen Teilbereich der Länge bzw. Breite der Solarzellenoberfläche erstrecken;
- Die Stapelanordnung 19 kann auch derart gewählt sein, dass jeweils nur auf der Oberseite bzw. nur auf der Unterseite der Solarzelle 7 Verbindungsleiter 8, 9 angeordnet sind, bzw. nur ein vereinzelter Verbindungsleiter 8, 9 zum Verlöten angeordnet wird.

## Patentansprüche

1. Verfahren zum Verlöten von Verbindungsleitern (8, 9, 35-38) mit den Anschlusskontakten (11, 12) einer Solarzelle (7, 43, 44), **dadurch gekennzeichnet, dass** vor dem Aufschmelzen des Lots (15, 17) auf die Anschlusskontakte (11, 12) die Solarzelle (7, 43, 44) und die Verbindungsleiter (8, 9, 35-38) in einer Stapelanordnung (19) aufeinanderliegend auf einer Ebene (3, 51) positioniert werden, so dass mindestens ein Verbindungsleiter (8, 9, 35-38) oberhalb und/oder mindestens ein Verbindungsleiter (8, 9, 35-38) unterhalb der Solarzelle (7, 43, 44) angeordnet ist, dass die Stapelanordnung (19) homogen erhitzt wird und dass mindestens ein Aktivierungsglied (4, 52-56, 70) von oben an die Stapelanordnung (19) herangeführt wird, durch welches an einem statischen Ort Ultraschallschwingungen auf die Stapelanordnung (19) übertragen werden und **dadurch** zusätzliche Energie zum flussmittelfreien Verlöten zugeführt wird.

2. Verfahren nach Anspruch 1, **dadurch gekennzeichnet, dass** durch das homogene Erhitzen ein Aufheizen der Stapelanordnung (19) auf eine Temperatur unterhalb der Löttemperatur durchgeführt wird und dass durch das Aktivierungsglied (4, 52-56, 70) zusätzliche Energie zum Erreichen der Löttemperatur auf die Stapelanordnung (19) übertragen wird.

3. Verfahren nach Anspruch 1 oder 2, **dadurch gekennzeichnet, dass** die Ebene eine Heizebene (3, 51) ist, in der Wärme erzeugt wird und an die Stapelanordnung (19) weitergeleitet wird, wodurch das homogene Erhitzen der Stapelanordnung (19) erzielt wird.

4. Verfahren nach einem der Ansprüche 1 bis 3, **dadurch gekennzeichnet, dass** durch mindestens ein Aktivierungsglied (4, 52-56, 70) sowohl in diesem erzeugte Wärme als auch durch dieses erzeugte Ultraschallschwingungen in die Stapelanordnung (19) eingeleitet werden.

5. Verfahren nach Anspruch 4, **dadurch gekennzeichnet, dass** nach dem Erreichen der Löttemperatur das Aktivierungsglied (4, 52-56, 70) von der Stapelanordnung (19) weggeführt wird, wobei mindestens ein Wärmeabführglied (5, 6, 57-62) mit der Stapelanordnung (19) in Kontakt steht.

6. Verfahren nach einem der Ansprüche 1 bis 5, **dadurch gekennzeichnet, dass** mindestens zwei Aktivierungsglieder (4, 52-56, 70) verwendet werden, wobei in dem zweiten Aktivierungsglied im Wesentlichen nur Wärme erzeugt wird.

7. Verfahren nach einem der Ansprüche 1 bis 6, **dadurch gekennzeichnet, dass** nach dem Heranführen des Aktivierungsglieds (4, 52-56, 70) zunächst nur in dem Aktivierungsglied erzeugte Wärme in die Stapelanordnung (19) eingeleitet wird und anschliessend zusätzlich Ultraschallschwingungen eingeleitet werden.

8. Verfahren nach einem der Ansprüche 1 bis 7, **dadurch gekennzeichnet, dass** die Verbindungsleiter (8, 9, 35-38) auf der zur Solarzelle (7, 43, 44) zugewandten Seite jeweils eine Beschichtung (15, 17) aufweisen, durch die ein Lot gebildet ist.

9. Verfahren nach einem der Ansprüche 1 bis 8, **dadurch gekennzeichnet, dass** durch eine Förder- oder Transfereinrichtung (45, 65) Solarzellen (7, 43, 44) zur Herstellung einer Solarzellenkette der Ebene (3, 51) aufeinanderfolgend zugeführt werden, wobei während des Verlötens einer Solarzelle (7, 43, 44) mit den Verbindungsleitern (8, 9, 35-38) auf der Ebene (3, 51) ein aufeinanderliegendes Positionieren von einer nachfolgend zu verlötenden Solarzelle und mindestens einem Verbindungsleiter (8, 9, 35-38) auf der Förder- oder Transfereinrichtung (45, 65) erfolgt.

10. Vorrichtung zum Verlöten von Verbindungsleitern (8, 9, 35-38) mit den Anschlusskontakten (11, 12) einer Solarzelle (7, 43, 44) durch ein Verfahren nach einem der Ansprüche 1 bis 9, **gekennzeichnet durch** eine Heizebene (3, 51) zum Positionieren der Solarzelle (7, 43, 44) und der Verbindungsleiter (8, 9, 35-38) in einer Stapelanordnung (19) und zur Erzeugung und Weiterleitung von Wärmeenergie an die Stapelanordnung (19) und **durch** mindestens ein Aktivierungsglied (4, 52-56, 70), das oberhalb der Heizebene (3, 51) angeordnet ist und von oben an die Stapelanordnung (19) heranführbar ist, wobei das Aktivierungsglied (4, 52-56, 70) zur Übertragung von Ultraschallschwingungen auf die Stapelanordnung (19) ausgebildet ist.

11. Vorrichtung nach Anspruch 10, **gekennzeichnet durch** mindestens ein Aktivierungsglied (4, 52-56, 70), das beheizbar ist und zur Übertragung von Ultraschallschwingungen ausgebildet ist.

12. Vorrichtung nach Anspruch 10 oder 11, **gekennzeichnet durch** mindestens ein weiteres Aktivierungsglied (4, 52-56, 70), das beheizbar ist.

13. Vorrichtung nach einem der Ansprüche 10 bis 12, **gekennzeichnet durch** mindestens ein Wärmeabführglied (5, 6, 57-62), das oberhalb der Heizebene (3, 51) angeordnet ist und von oben an die jeweilige Stapelanordnung (19) heranführbar ist.

14. Vorrichtung nach einem der Ansprüche 10 bis 13, **dadurch gekennzeichnet, dass** mehrere Aktivierungsglieder (4, 52-56, 70) und/oder Wärmeabführglieder (5, 6, 57-62) in einer Horizontalreihe parallel zur Heizebene (3, 51) angeordnet sind.

15. Vorrichtung nach Anspruch 14, **dadurch gekennzeichnet, dass** mindestens ein Aktivierungsglied (4, 52-56, 70) zur Erzeugung von Ultraschallschwingungen zwischen zwei beheizbaren Aktivierungsgliedern oder zwischen zwei Wärmeabführgliedern (5, 6, 57-62) angeordnet ist.

16. Vorrichtung nach einem der Ansprüche 10 bis 15, **dadurch gekennzeichnet, dass** das Aktivierungsglied (4, 52-56, 70) und/oder das Wärmeabführglied (5, 6, 57-62) im Wesentlichen zylinderförmig ausgebildet ist.

17. Vorrichtung nach einem der Ansprüche 10 bis 16, **dadurch gekennzeichnet, dass** das Aktivierungsglied (4, 52-56, 70) an seinem freien Ende eine mehrzähnige Oberflächenstruktur (71) aufweist.

18. Vorrichtung nach einem der Ansprüche 10 bis 17, **gekennzeichnet durch** eine vor und/oder hinter der Heizebene (3, 51) angeordnete Förder- oder Transfereinrichtung (45, 65) zum An- und Abtransport aufeinanderfolgender Solarzellen (7, 43, 44) einer herzustellenden Solarzellenkette in horizontaler Richtung.
